# EUROPÄISCHE PATENTANMELDUNG

(11) **EP 2 607 299 A1**
(43) Veröffentlichungstag der Anmeldung: **26.06.2013**
(21) Anmeldenummer: 12197389.5
(22) Anmeldetag: 17.12.2012
(51) Int. Cl.: B81C 99/00, G03F 7/00

(54) **Verfahren zum Herstellen eines Keramikwerkstücks**

(30) Priorität: 23.12.2011 DE 102011056962
(71) Anmelder: BPE e. K., 90542 Eckental (DE)
(72) Erfinder: Dr. Hornig, Wolfgang, 90542 Eckental (DE)
(74) Vertreter: Kaufmann, Sigfrid

(57) **Zusammenfassung**

Die Erfindung betrifft ein Verfahren zum Herstellen eines mikrostrukturierten Werkstücks aus einer Keramik, aufweisend das Bereitstellen eines Grünkörpers aus ungebrannter Keramik; das Brennen des Grünkörpers unter Ausbildung eines Rohlings; und das Ausbilden des Rohlings aus der gebrannten Keramik mit einem Strukturmuster, das Strukturen mit Abmessungen von kleiner als 1000 µm aufweist, mittels Fräsens des Rohlings mit einem Fräswerkzeug; wobei vor dem Brennen des Grünkörpers ein Ausbilden des Grünkörpers mit einer dem Strukturmuster entsprechenden Vorstrukturierung erfolgt .

## Beschreibung

Die Erfindung betrifft ein Verfahren zum Herstellen eines mikrostrukturierten Werkstücks, z.B. eines Prägewerkzeugs, aus einer Keramik und ein nach diesem Verfahren hergestelltes Werkstück.

Gebrannte Keramiken, insbesondere technischen Keramiken, zeichnen sich unter anderem durch ihre hohe mechanische Beständigkeit, wie z.B. hohe Abrieb- und Verschleißfestigkeit, große Härte und hohe mechanische Festigkeit, aus. Bei der Herstellung von Keramikwerkstücken wird zunächst ein entsprechender Grünkörper, d.h. ein Körper aus einer ungebrannten Keramik, die sich noch leicht bearbeiten lässt, geformt (z.B. mittels Verpressens oder Verklebens von Keramikpulver) und der geformte Grünkörper unter Ausbildung des Werkstücks gebrannt. Beim Brennen findet stets ein Schwund und zusätzlich dazu eine (leichte) Deformation (z.B. aufgrund von Material- und/oder Temperaturinhomogenitäten, aber auch aufgrund der hohen Brenntemperaturen an sich) des Grünkörpers statt; wobei der Schwund und die Deformation bei der Herstellung von Keramikwerkstücken zu berücksichtigen sind. Insbesondere erfolgt durch den Brennprozess z.B. ein Abrunden winklig vorgeformter Kanten. Jedoch variieren sowohl der Schwund als auch die Deformation mit der Materialzusammensetzung der jeweiligen Materialcharge und mit den Brennparametern des jeweiligen Brennprozesses, sodass die Abmessungen bzw. die Form des gebrannten Werkstücks stets entsprechenden Ungenauigkeiten unterliegt. Dadurch wird die Herstellung von Werkstücken mit einer reproduzierbaren Maßhaltigkeit erschwert bzw. sogar verhindert, sodass insbesondere das formgenaue Herstellen von Keramikwerkstücken mit kleinen Formelementen, die z.B. Abmessungen im µm-Bereich aufweisen und eine hochgenaue Formgebung erfordern, erschwert ist.

Die EP 2 327 524 A1 beschreibt einen Prägestempel mit einer Mikrostrukturierung. Die WO 2008/135454 A1 beschreibt ein Werkzeug zum hochgenauen Mikrofräsen.

Die DE 199 04 635 A1 beschreibt Teststrukturen zur Überprüfung der Abbildungseigenschaften eines auf der Magnetresonanz beruhenden bildgebenden Gerätes, bestehend im wesentlichen aus Strukturelementen unterschiedlicher Größe, welche sich in einem Behälter befinden, der mit einem NMR-aktiven Material gefüllt ist, wobei die Strukturelemente aus keramischem oder Halbleiter- oder Lack- bzw. Polymer-Basismaterial bestehen, aus welchem Hohlräume mit Strukturgrößen kleiner als 600 µm durch Mikrostrukturierungsverfahren herausgearbeitet sind, wobei die Hohlraum-Strukturen z.B. mittels mechanischer Trenn-, Fräs-, Säge oder Schneideverfahren aus dem Basismaterial herausgearbeitet werden.

Die DE 198 41 785 A1 beschreibt Verfahren zur Herstellung eines Körpers mit Mikrostrukturen aus thermisch aufgespritztem Material, umfassend folgende Schritte: Aufbringen einer Schicht eines strahlungsempfindlichen Kunststoffs auf eine Oberfläche eines Substrats; Mikrostrukturieren der Kunststoffschicht mittels eines lithographischen Verfahrens; Aufbringen mindestens eines Materials auf die die mikrostrukturierte Kunststoffschicht aufweisende Oberfläche des Substrats durch thermisches Spritzen; und Entfernen der mikrostrukturierten Kunststoffschicht und/oder des Substrats bzw. Abtragen von aufgespritztem Material mindestens bis zur Höhe der Oberkante der Mikrostrukturen der Kunststoffschicht.

Durch die Erfindung wird ein kosteneffektives Verfahren zum Herstellen eines mikrostrukturierten Werkstücks aus einer Keramik bereitgestellt, mittels dessen eine exakte, reproduzierbare Formgebung des Werkstücks ermöglicht und somit eine hohe Maßhaltigkeit gewährleistbar ist. Dazu wird ein Verfahren mit den Merkmalen gemäß Anspruch 1 bereitgestellt, Ausführungsformen des Verfahrens ergeben sich aus den abhängigen Ansprüchen; zudem wird gemäß Anspruch 10 ein mittels eines solchen Verfahrens hergestelltes Werkstück bereitgestellt.

Gemäß der Erfindung wird ein Verfahren zum Herstellen eines mikrostrukturierten Werkstücks aus einer Keramik bereitgestellt. Gemäß dem Verfahren wird ein Rohling aus einer gebrannten Keramik mittels Fräsens mit einem Fräswerkzeug (d.h. durch Materialabtrag an dem Rohling mittels Fräsens) mit einem vorgegebenen Strukturmuster, das Strukturen mit Abmessungen bzw. Dimensionen von kleiner als 1000 µm aufweist, ausgebildet bzw. versehen (wobei das Strukturmuster nicht ausschließlich Strukturen mit Abmessungen von kleiner als 1000 µm aufweisen muss). Der Begriff "mikrostrukturiert" bezieht sich hier auf eine Strukturierung mit Abmessungen im µm-Bereich, d.h. von kleiner als 1000 µm.

Indem die Formgebung nicht an einem Grünkörper aus ungebrannter Keramik, sondern an dem Rohling aus der bereits gebrannten Keramik erfolgt, kann ein Verformen des Strukturmusters aufgrund von Schwund und/oder einer Deformation des Keramikmaterials während des Brennens vermieden werden und somit eine exakte, reproduzierbare Formgebung des Werkstücks ermöglicht werden. Insbesondere ermöglicht das Ausbilden des Strukturmusters in der gebrannten Keramik das Ausbilden von scharfen (d.h. nicht abgerundeten) Kanten. Aufgrund der hohen Genauigkeit bei der Formgebung und der hohen Reproduzierbarkeit können der Ausschussanteil reduziert und somit die Herstellungskosten gesenkt werden.

Beim Herstellen von Strukturmustern bzw. Formen mit großen Strukturabmessungen (von z.B. größer als 1 mm) können der Schwund und die Deformation während des Brennens hinreichend genau vorhergesagt werden, wobei die aufgrund der Chargenabhängigkeit und der Abhängigkeit vom jeweiligen Brennprozess verbleibende Formungenauigkeit relativ zu den Strukturabmessungen vernachlässigbar ist. Bei Werkstücken mit einer Mikrostrukturierung, d.h. mit einer Struktur mit Abmessungen im Bereich von kleiner als 1000 µm (z.B. im Bereich zwischen 0,1 µm und 1000 µm), kann diese verbleibende Formungenauigkeit jedoch oftmals nicht toleriert werden.

Die Keramik kann z.B. eine Oxid-Keramik (z.B. eine Aluminiumoxid-Keramik) oder eine Nicht-Oxid-Keramik (z.B. eine Aluminiumnitrid-Keramik) sein. Das Strukturmuster wird mittels Materialabtrags durch Fräsen, z.B. an einer Seitenfläche des gebrannten Rohlings, in bzw. an dem Rohling ausgebildet. Das Fräswerkzeug kann z.B. ein Diamant-Fräswerkzeug (d.h. ein Fräswerkzeug mit Diamant als Schneidstoff) oder ein Hartmetall-Fräswerkzeug (d.h. ein Fräswerkzeug mit einem Hartmetall als Schneidstoff) sein. Zum Fräsen kann eine konventionelle Fräsvorrichtung, z.B. eine Präzisionsfräsvorrichtung, verwendet werden. Die Keramik kann auch eine supraleitende Keramik (z.B. eine Hochtemperatursupraleiter-Keramik) oder eine Piezokeramik sein. Die Keramik kann auch eine beliebige technische Keramik sein.

Das (herzustellende) Werkstück kann z.B. ein Prägewerkzeug sein, z.B. zur Verwendung als Urform zum Einprägen von Mikrostrukturen in dafür vorgesehene Präge-Rohlinge, die z.B. aus einem Polymer bestehen können, z.B. aus Polymethylmethacrylat (PMMA). Das Werkstück kann auch ein Werkstück mit einer optischen und/oder fluidischen Mikrostruktur sein, wobei die optischen und/oder fluidischen Mikrostruktur von dem bzw. mittels des eingebrachten Strukturmusters gebildet wird. Des Weiteren kann vorgesehen sein, dass das Werkstück ein Präzisionswerkzeug ist oder einen Teil eines Präzisionswerkzeugs bildet. Mikro- und nanostrukturierte Keramiken (bzw. Werkstücke mit Mikro- oder Nanostrukturen aus Keramik) sind insbesondere wegen ihres sehr geringen thermischen Ausdehnungskoeffizienten vorteilhaft, und sind daher z.B. als Werkzeuge für hohe Temperaturen gut geeignet.

Das Strukturmuster kann z.B. in Form eines Kennzeichnungscodes bzw. einer Kennzeichnung (z.B. eines Codes, einer Echtheitskennzeichnung oder eines Herstellerkennzeichens) ausgebildet sein. Das Strukturmuster kann z.B. eine Kennzeichnung zum Kennzeichnen des Keramikwerkstücks an sich sein. Demgemäß kann das beschriebene Verfahren zum Ausbilden von Keramikwerkstücken bzw. Keramikprodukten mit Mikro- oder Nano-Codes (d.h. Kennzeichnungen bzw. Kennzeichnungscodes mit Strukturabmessungen im Mikrometer- bzw. Nanometerbereich, siehe oben) verwendet werden.

Das (herzustellende) Werkstück kann jedoch auch ein Stempel, z.B. ein Prägestempel bzw. Prägewerkzeug, sein. Das Werkstück kann insbesondere ein Keramikwerkzeug für die Glasherstellung bzw. Glasverarbeitung sein, z.B. ein zum Prägen von Glasstrukturen vorgesehenes Prägewerkzeug (z.B. ein Stempel bzw. Prägestempel). Das Werkstück kann z.B. ein Keramikstempel zum Stempeln oder Prägen eines Kennzeichens (z.B. eines Codes, einer Echtheitskennzeichnung oder eines Herstellerkennzeichens) in Glas bzw. in ein Glasprodukt sein, wobei das Kennzeichen mittels des in dem Werkstück ausgebildeten Strukturmusters gebildet ist. In diesem Fall ist das Strukturmuster in Form eines entsprechenden Kennzeichnungscodes zum Kennzeichnen des zu prägenden Produkts (z.B. zum Kennzeichnen eines Glasprodukts) ausgebildet. Des Weiteren kann das (herzustellende) Werkstück z.B. eine Keramikauflage für die Glasfensterherstellung sein. Es hat sich herausgestellt, dass bei Kontakt eines solchen mikrostrukturierten Keramikwerkstücks mit heißem Glas (z.B. Glasschmelze) sich das Keramikwerkstück nach der Bearbeitung (z.B. nach dem Prägen des Glases mittels des Keramikwerkstücks) gut von dem Glas separieren lässt, d.h. kein Anhaften bzw. Kleben der Keramikoberfläche an dem Glas erfolgt (im Gegensatz zu der Bearbeitung von Glas mit Metallwerkzeugen).

Das Strukturmuster kann z.B. Stege (bzw. Rippen) mit Breiten und/oder Höhen von kleiner als 1000 µm und/oder Kanäle mit Breiten und/oder Tiefen von kleiner als 1000 µm (z.B. im Bereich zwischen 0,1 µm und 1000 µm) aufweisen oder aus solchen Stegen und/oder Kanälen bestehen. Indem die Stege mittels Fräsens in dem gebrannten, harten Rohling ausgebildet werden, können die Stege sowohl an ihrer Basis als auch an ihrer Oberseite mit scharfen (d.h. wohldefinierten, nicht bzw. lediglich geringförmig abgerundeten und somit einen geringen Krümmungsradius aufweisenden) Kanten ausgebildet werden. Der Querschnitt der Stege und/oder der Kanäle kann z.B. rechtwinklig bzw. rechteckförmig sein, mittels entsprechender Ausgestaltung des Fräswerkzeugs kann jedoch auch eine beliebige andere Querschnittsform vorgesehen sein. Zum Beispiel kann mittels einer entsprechenden Form des Fräswerkzeugs vorgesehen sein, die Stege mit schrägen Seitenwänden, z.B. mit einem kegelstumpfförmigen Querschnitt, auszubilden.

Der Begriff "Fräsen" umfasst hier jegliche Art von Materialabtrag mittels einer Relativrotation zwischen dem gebrannten Rohling und dem Fräswerkzeug, wobei z.B. entweder das Fräswerkzeug gegenüber dem stationär angeordneten (z.B. fest eingespannten) gebrannten Rohling rotiert oder der gebrannte Rohling gegenüber dem stationär angeordneten (z.B. fest eingespannten) Fräswerkzeug rotiert. Der Begriff "Fräsen" umfasst hier somit auch den Materialabtrag mittels Drehens und Schleifens. Es kann auch vorgesehen sein, neben den mittels Fräsens eingebrachten Strukturen weitere Strukturen mittels Prägens, z.B. mittels Mikroprägens, in dem Werkstück auszubilden, sodass z.B. mittels Fräsens und Mikroprägens erzeugte Mischstrukturen gebildet werden können.

Das Herstellungsverfahren weist ferner die Schritte des Bereitstellens eines Grünkörpers aus ungebrannter Keramik und des Brennens (bzw. Sinterns) des Grünkörpers unter Ausbildung des Rohlings auf (wobei im Folgenden der Begriff "Rohling" den bereits gebrannten Rohling bezeichnet, falls sich nicht aus dem Kontext etwas anderes ergibt). Der Grünkörper ist z.B. ein (ungebrannter) Grünkörper mit ebenen Seitenflächen. Demgemäß kann der (gebrannte) Rohling auf einfache Art und Weise mittels eines Grünkörpers hergestellt werden.

Das Verfahren weist vor dem Brennen ferner den Schritt des Ausbildens des Grünkörpers mit einer dem Strukturmuster entsprechenden Vorstrukturierung auf. Das Strukturmuster wird durch Ausbilden/Einbringen von Strukturmuster-Ausnehmungen (mittels Fräsens) in dem/den gebrannten Rohling gebildet. Die Vorstrukturierung (bzw. das Vorstrukturierungs-Muster) wird durch Ausbilden/Einbringen (z.B. mittels Fräsens) von den Strukturmuster-Ausnehmungen entsprechenden Vorform-Ausnehmungen in dem/den Grünkörper gebildet. Die Vorform-Ausnehmungen sind (mit entsprechenden Abmessungen) derart ausgebildet, dass sie (unter Berücksichtigung des während des Brennens stattfindenden Schwundes) nach dem Brennen Abmessungen aufweisen, die (zumindest teilweise) kleiner sind als die entsprechenden Abmessungen der jeweils zugehörigen Strukturmuster-Ausnehmungen, sodass die Vorform-Ausnehmungen nach dem Brennen mittels Fräsens unter Ausbildung der Strukturmuster-Ausnehmungen aufgeweitet werden können. Es kann z.B. vorgesehen sein, die Vorform-Ausnehmungen bereits in dem Grünkörper (d.h. vor einem etwaigen Schwund durch Brennen) mit Abmessungen auszubilden, die kleiner sind als die jeweils entsprechenden Abmessungen der vorgesehenen Strukturmuster-Ausnehmungen.

Demgemäß kann ein Großteil des Materialabtrags in dem weichen, leicht zu bearbeitenden Grünkörper erfolgen und an dem harten, gebrannten Rohling lediglich ein geringer Materialabtrag erforderlich sein, sodass z.B. der Verschleiß des Fräswerkzeugs reduziert werden kann.

Gemäß einer Ausführungsform weist das Verfahren vor dem Ausbilden des Strukturmusters ferner den Schritt des Temperierens des gebrannten Rohlings auf eine vorgegebene Temperatur auf, wobei die vorgegebene Temperatur z.B. oberhalb der Raumtemperatur liegen kann (z.B. oberhalb von 20 °C).

Zum Beispiel kann vorgesehen sein, den (gebrannten) Rohling nach dem Brennprozess bei einer unterhalb der Brenntemperatur liegenden Temperatur einem Temperier- bzw. Glühvorgang zu unterziehen, wodurch z.B. in dem Rohling vorliegende innere (mechanische) Spannungen abgebaut werden können. Solche inhomogenen inneren Spannungen könnten z.B. beim oder nach dem Ausbilden bzw. Einbringen des Strukturmusters zu einer (nachträglichen) Verformung des eingebrachten Musters führen.

Als ein anderes Beispiel kann mittels eines solchen Temperierens sichergestellt werden, dass beim Ausbilden des Strukturmusters (d.h. beim Fräsen) über den gesamten Rohling hinweg eine homogene Temperaturverteilung (d.h. die gleiche Temperatur) vorliegt und dass bei unterschiedlichen Rohlingen (z.B. bei der aufeinanderfolgenden Herstellung zweier Werkstücke) die Temperatur während des Ausbildens des Strukturmusters stets gleich ist. Dadurch können z.B. aus Temperaturunterschieden (entsprechend dem Wärmeausdehnungskoeffizienten der gebrannten Keramik) resultierende Variationen in den Abmessungen des Strukturmusters sowohl zwischen unterschiedlichen Stellen ein und desselben Rohlings als auch zwischen unterschiedlichen Rohlingen unterdrückt werden.

Es kann vorgesehen sein, die Temperierung während des Ausbildens des Strukturmusters (d.h. während des Fräsens) aufrechtzuerhalten und den derart temperierten Rohling zu fräsen, wobei in diesem Fall aufgrund des Wärmeeintrags durch das Fräsen eine entsprechende (leicht) inhomogene Temperaturverteilung über den Rohling hinweg vorliegen kann.

Das Temperieren kann z.B. mittels Heizens des (gebrannten) Rohlings erfolgen. In diesem Fall kann z.B. (insbesondere zu Beginn des Fräsens) sichergestellt werden, dass der Temperaturgradient, der durch den durch das Fräsen erfolgenden Wärmeeintrag im Rohling hervorgerufen wird, relativ klein und z.B. unterhalb eines vorgegebenen Wertes gehalten werden kann. Da ein solcher Temperaturgradient auch immer (mechanische) Spannungen hervorruft und unterschiedliche Temperaturen entsprechend dem Wärmeausdehnungskoeffizienten mit einer entsprechenden räumlichen Variation der Materialeigenschaften einhergehen, können durch ein Reduzieren des Temperaturgradienten die Maßhaltigkeit bzw. die Maß- und Positionsgenauigkeit bei der Herstellung des Werkstücks gesteigert werden.

Gemäß einer weiteren Ausführungsform ist die Korngröße (die (maximale) Kornquerschnittsabmessung bzw. der (maximale) Korndurchmesser) der gebrannten Keramik kleiner als die kleinste Abmessung des Strukturmusters. Zum Beispiel kann vorgesehen sein, dass die maximale Korngröße der gebrannten Keramik kleiner ist als die kleinste Abmessung des in dem gebrannten Rohling auszubildenden Strukturmusters. Es kann z.B. vorgesehen sein, dass die Korngröße kleiner ist als 1/2, 1/5 oder 1/10 der kleinsten Strukturabmessung; wobei unter der kleinsten Strukturabmessung die Abmessung des kleinsten Strukturelements des Strukturmusters zu verstehen ist.

Das Ausgangsmaterial beim Herstellen keramischer Bauteile liegt in Form von Keramikpulver mit einer bestimmten Korngröße vor. Beim Brennen bzw. Sintern bleibt die Korngröße je nach Brenntemperatur und Material entweder erhalten oder nimmt zu, sodass die in dem gebrannten Rohling vorliegende Korngröße z.B. durch entsprechende Auswahl der Brennparameter und/oder des keramischen Ausgangsmaterials derart eingestellt werden kann, dass die resultierende Korngröße in der gebrannten Keramik kleiner ist als die kleinste vorgesehene Strukturabmessung. Es wurde festgestellt, dass beim Fräsen, vor allem bei geringen Drehzahlen und kleinen Korngrößen, der Materialabtrag großteils erfolgt, indem ganze Körner entlang ihrer Korngrenze aus dem gebrannten Material herausgelöst werden. Gemäß der vorliegenden Ausführungsform kann durch Anpassen der Korngröße an die Abmessungen des vorgesehenen Strukturmusters auch bei kleinen Drehzahlen (und entsprechend kleinem Wärmeeintrag durch das Fräsen) des Fräswerkzeugs sichergestellt werden, dass die das Strukturmuster bildenden Ausnehmungen im Vergleich zu den Strukturabmessungen scharfe, wohldefinierte Kanten mit einer geringen Kantenrauhigkeit und Seitenflächen mit einer geringen Flächenrauhigkeit aufweisen.

Es kann auch vorgesehen sein, dass die (maximale) Korngröße kleiner gewählt ist als ein vorgegebener Rauhigkeitswert für die Kantenrauhigkeit und/oder die Flächenrauhigkeit des zu bildenden Strukturmusters; z.B. kleiner als 1/2, 1/5 oder 1/10 des vorgegebenen Rauhigkeitswertes.

Gemäß einer weiteren Ausführungsform ist die (maximale) Porengröße der gebrannten Keramik (d.h. die maximale Größe von in der Keramik vorliegenden Poren) kleiner als die kleinste Abmessung des Strukturmusters, z.B. kleiner als 1/2, 1/5 oder 1/10 der kleinsten Strukturabmessung. Es kann auch vorgesehen sein, dass die (maximale) Porengröße kleiner ist als ein vorgegebener Rauhigkeitswert für die Kantenrauhigkeit und/oder die Flächenrauhigkeit des zu bildenden Strukturmusters; z.B. kleiner als 1/2, 1/5 oder 1/10 des vorgegebenen Rauhigkeitswertes. Gemäß dieser Ausführungsform kann analog zu oben hinsichtlich der Korngröße beschriebener Wirkungsweise sichergestellt werden, dass die das Strukturmuster bildenden Ausnehmungen im Vergleich zu den Strukturabmessungen scharfe, wohldefinierte Kanten mit einer geringen Kantenrauhigkeit und Seitenflächen mit einer geringen Flächenrauhigkeit aufweisen.

Gemäß einem weiteren Aspekt der Erfindung wird ein (mikrostrukturiertes) Werkstück aus Keramik bereitgestellt, das nach einem der soeben beschriebenen Verfahren hergestellt ist.

Die Erfindung wird im Folgenden anhand eines Ausführungsbeispiels mit Bezugnahme auf die beiliegenden Zeichnungen erläutert, wobei gleiche oder ähnliche Merkmale mit gleichen Bezugszeichen versehen sind. In den Zeichnungen zeigen:

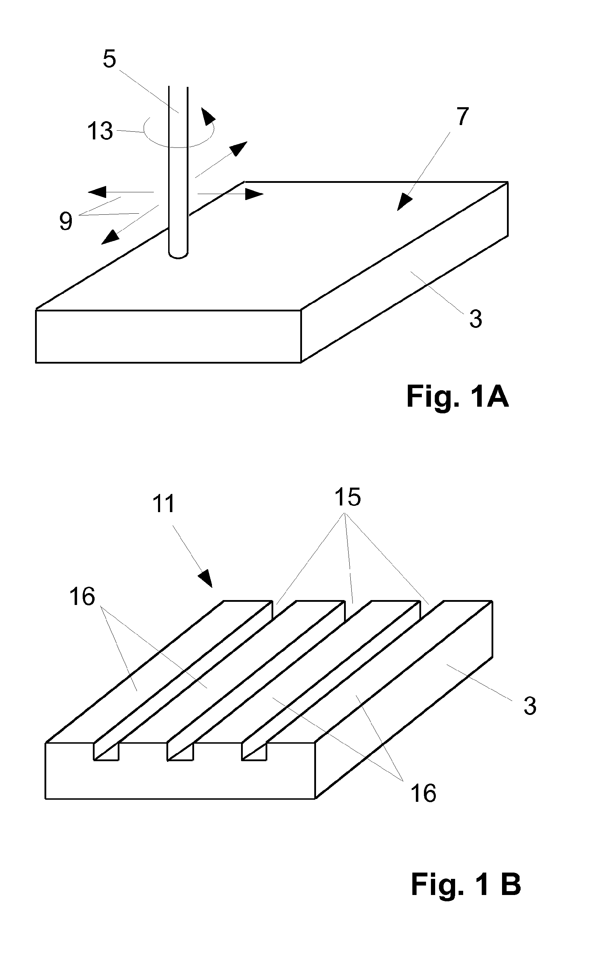

- **Figuren 1A bis 1 D**: eine schematische Illustration eines Verfahrens gemäß einer Ausführungsform der Erfindung;

Die Figuren 1A bis 1D veranschaulichen ein Verfahren gemäß einer Ausführungsform zum Herstellen eines mikrostrukturierten Werkstücks 1 in Form eines Prägewerkzeugs 1. Gemäß Figur 1A wird in einem ersten Schritt ein unstrukturierter Grünkörper 3 aus einer ungebrannten Keramik (hier: Aluiniumnitrid) bereitgestellt. Der Grünkörper 3 wird durch Materialabtrag mittels eines Fräswerkzeugs 5, das entlang der oberen Seitenfläche 7 des Grünkörpers verfahren wird (in Figur 1A veranschaulicht durch die Pfeile 9), mit einer Vorstrukturierung bzw. einem Vorstrukturierungs-Muster 11 ausgebildet bzw. versehen. In Fig. 1A ist die Rotation des Fräswerkzeugs 5 durch den Pfeil 13 angedeutet. Figur 1B veranschaulicht den Grünkörper 3 mit dem fertig ausgebildeten Vorstrukturierungs-Muster 11, welches hier aus drei an der Oberseite 7 des Grünkörpers 3 ausgebildeten Vorstruktur-Kanälen 15 und vier mittels derselben gebildeten Vorstruktur-Stegen 16 besteht. Die Breite der Vorstruktur-Kanäle 15 gemäß Figur 1B beträgt als Beispiel 0,5 mm.

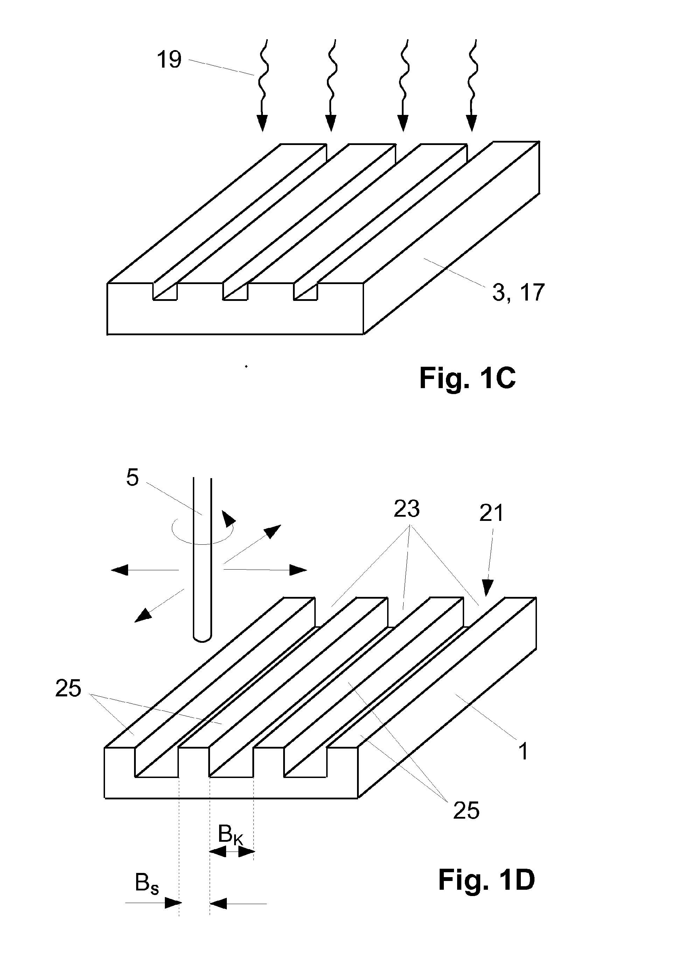

In einem nächsten Schritt wird der (ungebrannte) vorstrukturierte Grünkörper 3 bei einer Brenntemperatur T (hier: ca. 1800 °C) unter Ausbildung des (gebrannten) Rohlings 17 gebrannt bzw. gesintert (in Figur 1C veranschaulicht durch die Pfeile 19), wobei insbesondere ein Schwund des Keramikmaterials erfolgen kann (nicht dargestellt). Nach Abschluss des Brennvorgangs wird der Rohling 17 zunächst abgekühlt und anschließend mittels Heizens auf eine Temperatur von ca. 50 °C temperiert (nicht dargestellt).

In einem nächsten Schritt wird (siehe Fig. 1 D) der Rohling 17 aus der gebrannten Keramik mittels Fräsens mit dem Fräswerkzeug 5 mit einem Strukturmuster 21 ausgebildet bzw. versehen, wobei das Fräswerkzeug hier als Beispiel mit dem zum Ausbilden des Vorstrukturierungs-Musters 11 verwendeten Fräswerkzeug 5 identisch ist. Das Fräswerkzeug 5 ist mit Diamant als Schneidstoff ausgebildet.

Gemäß Figur 1D wird das Strukturmuster 21 unter Ausbildung des Werkstücks 1 mittels Fräsens des Rohlings 17 ausgebildet, indem die Vorstruktur-Kanäle 15 mittels Fräsens zu Kanälen 23 aufgeweitet werden, deren Breite und Tiefe größer ist als die Breite bzw. Tiefe der Vorstruktur-Kanäle 15. Das Strukturmuster 21 besteht hier aus den drei Kanälen 23 und vier mittels derselben gebildeten Stegen 25, wobei die Breite B_{K} der Kanäle 23 als Beispiel 1 mm und die Breite B_{S} der Stege 45 µm beträgt (die Figuren sind der besseren Übersichtlichkeit halber nicht maßstabsgerecht).

Gemäß Figur 1D bildet als Beispiel die Breite B_{S} der Stege 23 (von 45 µm) die kleinste Abmessung des Strukturmusters 21 (insbesondere beträgt die Höhe und die Länge der Stege 23 mehr als 45 µm). Das keramische Ausgangsmaterial und die Brennparameter (z.B. die Brenntemperatur und die Brenndauer) sind derart gewählt, dass die maximale Korngröße bzw. der maximale Korndurchmesser (nicht dargestellt) der gebrannten Keramik des Rohlings 17 kleiner als 1/5 der Breite der Stege 23 (d.h. kleiner als 1/5 der kleinsten Abmessung des Strukturmusters 21) ist, d.h. im vorliegenden Fall kleiner als 9 µm. Zudem sind das keramische Ausgangsmaterial und die Brennparameter (z.B. die Brenntemperatur und die Brenndauer) derart gewählt, dass die maximale Porengröße bzw. der maximale Porendurchmesser (nicht dargestellt) der Poren der gebrannten Keramik des Rohlings 17 kleiner als 1/5 der Breite der Stege 23 (d.h. kleiner als 1/5 der kleinsten Abmessung des Strukturmusters 21) ist, d.h. im vorliegenden Fall kleiner als 9 µm.

### Liste der verwendeten Bezugszeichen

- 1: mikrostrukturiertes Werkstück / Prägewerkzeug
- 3: (ungebrannter) Grünkörper
- 5: Fräswerkzeug
- 7: zu strukturierende Seite des Grünkörpers
- 9: Verfahrbewegung des Fräswerkzeugs
- 11: Vorstrukturierung / Vorstrukturierungs-Muster
- 13: Rotationsbewegung des Fräswerkzeugs
- 15: Kanäle des Vorstrukturierungs-Musters
- 16: Stege des Vorstrukturierungs-Musters
- 17: (gebrannter) Rohling
- 19: Brennen des Grünkörpers
- 21: Strukturmuster
- 23: Kanäle des Strukturmusters
- 25: Stege des Strukturmusters
- B_{K}: Breite der Kanäle des Strukturmusters
- B_{S}: Breite der Stege des Strukturmusters

## Patentansprüche

1. Verfahren zum Herstellen eines mikrostrukturierten Werkstücks (1) aus einer Keramik, aufweisend die Schritte:
- Bereitstellen eines Grünkörpers (3) aus ungebrannter Keramik,
- Brennen des Grünkörpers (3) unter Ausbildung eines Rohlings (17), und
- Ausbilden des Rohlings (17) aus der gebrannten Keramik mit einem Strukturmuster (21), das Strukturen (25) mit Abmessungen (B_{S}) von kleiner als 1000 µm aufweist, mittels Fräsens des Rohlings (17) mit einem Fräswerkzeug (5), **dadurch gekennzeichnet, dass**
- vor dem Brennen des Grünkörpers (3) ein Ausbilden des Grünkörpers (3) mit einer dem Strukturmuster (21) entsprechenden Vorstrukturierung (11) erfolgt.

2. Verfahren nach Anspruch 1, ferner aufweisend den Schritt:
- Temperieren des gebrannten Rohlings (17) auf eine vorgegebene Temperatur vor dem Einbringen des Strukturmusters (21).

3. Verfahren nach Anspruch 2, wobei das Temperieren ein Heizen ist.

4. Verfahren nach einem der Ansprüche 1 bis 3, wobei die Korngröße der gebrannten Keramik kleiner ist als die kleinste Abmessung (B_{S}) des Strukturmusters (21).

5. Verfahren nach einem der Ansprüche 1 bis 4, wobei die Porengröße der gebrannten Keramik kleiner ist als die kleinste Abmessung (B_{S}) des Strukturmusters (21).

6. Verfahren nach einem der Ansprüche 1 bis 5, wobei das Fräswerkzeug (5) ein Diamant-Fräswerkzeugs ist.

7. Verfahren nach einem der Ansprüche 1 bis 5, wobei das Fräswerkzeug (5) ein Hartmetall-Fräswerkzeug ist.

8. Verfahren nach einem der Ansprüche 1 bis 7, wobei das Werkstück ein Prägewerkzeug ist.

9. Verfahren nach einem der Ansprüche 1 bis 8, wobei das Strukturmuster in Form eines Kennzeichnungscodes ausgebildet ist.

10. Werkstück, hergestellt nach dem Verfahren gemäß einem der Ansprüche 1 bis 9.

11. Werkstück nach Anspruch 10, wobei das Werkstück ein Prägewerkzeug ist.

12. Werkstück nach Anspruch 11, wobei das Werkstück ein Prägewerkzeug zum Prägen von Glas ist.
